# EUROPEAN PATENT APPLICATION

(11) **EP 4 357 853 A1**
(43) Date of publication of application: **24.04.2024**
(21) Application number: 22201858.2
(22) Date of filing: 17.10.2022
(51) Int. Cl.: G03F 7/20, G03F 9/00, G02B 26/08, G02B 27/10

(54) **APPARATUS AND METHODS FOR FILTERING MEASUREMENT RADIATION**

(71) Applicant: ASML Netherlands B.V., 5500 AH Veldhoven (NL)
(72) Inventor: ZHOU, Zili, 5500 AH Veldhoven (NL); ARABUL, Mustafa, Ümit, 5500 AH Veldhoven (NL); BRULS, Dominique, Maria, 5500 AH Veldhoven (NL)
(74) Representative: ASML Netherlands B.V.

(57) **Abstract**

A source selection module comprising an adjustable diffraction element comprising multiple pixels. The source selection module further comprises a light dispersive element configured for receiving a first and a second light. The light dispersive element distributes the first light over a first pixel to generate a zeroth and a non-zeroth diffraction order. The light dispersive element further spatially distributes the second light over a second pixel to generate a zeroth and a non-zeroth diffraction order. The source selection module comprises a continuous variable filter comprising a first and a second area. The zeroth order of the first light received by the first area and the zeroth order of the second light received by the second area are transmitted or reflected. The non-zeroth order of the first light is blocked outside of the first area, and the non-zeroth order of the second light is blocked outside of the second area.

## Description

### FIELD

The present invention relates to methods and apparatus usable, for example, in the manufacture of devices by lithographic techniques, and to methods of manufacturing devices using lithographic techniques. The invention relates more particularly to metrology sensors and lithography apparatuses having such a metrology sensor, and more particularly still to illumination arrangements for such metrology sensors.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiationsensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In some metrology applications, such as in some scatterometers or alignment sensors, imperfections in metrology targets can result in a wavelength/polarization dependent variation in a measured value from that target. As such, correction and/or mitigation for this variation is sometimes effected by performing the same measurement using multiple different wavelengths and/or polarizations (or more generally, multiple different illumination conditions). It would be desirable to improve switching and selection of the spectral components of illumination for such metrology applications.

### SUMMARY

According to an aspect of the current disclosure, there is provided a source selection module comprising an adjustable diffraction element comprising multiple pixels. The source selection module further comprises a light dispersive element configured for receiving a first light of a first wavelength and a second light of a second wavelength. The light dispersive element spatially distributes the first light over a first pixel of the multiple pixels to generate a zeroth diffraction order of the first light and a non-zeroth diffraction order of the first light. The light dispersive element further spatially distributes the second light over a second pixel of the multiple pixels to generate a zeroth diffraction order of the second light and a non-zeroth diffraction order of the second light. The source selection module comprises a continuous variable filter comprising a first area and a second area. The continuous variable filter is arranged at a position such that the zeroth order of the first light received by the first area and the zeroth order of the second light received by the second area are transmitted or reflected by the continuous variable filter. The non-zeroth order of the first light is blocked by the continuous variable filter outside of the first area, and the non-zeroth order of the second light is blocked by the continuous variable filter outside of the second area.

Optionally, each of the multiple pixels may comprise a controllable grating.

Optionally, the adjustable diffraction element may comprise a grating light valve.

Optionally, the continuous variable filter may be arranged on an optical path between the light dispersive element and the adjustable diffraction element.

Optionally, the continuous variable filter may be arranged at a distance from the adjustable diffraction element or at a distance from a conjugate image plane of the adjustable diffraction element, such that the zeroth diffraction order and non-zeroth diffraction order of the first light and the zeroth diffraction order and non-zeroth diffraction order of the second light are spatially separated.

Optionally, the light dispersive element may comprise a prism.

Optionally, the light dispersive element may comprise a light dispersive grating.

Optionally, the continuous variable filter ma comprise a continuously varying bandpass layer.

Optionally, a plane of the continuous variable filter may be tilted relative to a plane of the adjustable diffraction element.

Optionally, a filtering characteristic for transmitting/reflection and blocking radiation is linearly distributed over the area of the continuous variable filter.

Optionally, module according to any of claims 1 to 9, wherein a filtering characteristic is non-linearly distributed over the area of the continuous variable filter.

Optionally, the continuous variable filter may have a first optical filtering characteristic in the first area and a second optical filtering characteristics in the second area.

Optionally, the first wavelength and the second wavelength may both be in a range from 400 nm - 900 nm. In some implementations the first wavelength and the second wavelength may both be in a range from 400nm to 2000 nm.

According to another aspect of the current disclose there is provided a method. A first light of a first wavelength and a second light of a second wavelength are received. A light dispersive element spatially distributed the first light over a first pixel of an adjustable diffraction element comprising multiple pixels, and spatially distributes the second light over a second pixel of the multiple pixels of the adjustable diffraction element. The first pixel generates a zeroth diffraction order of the first light and a non-zeroth diffraction order of the first light. The second pixel generates a zeroth diffraction order of the second light and a non-zeroth diffraction order of the second light. A continuous variable filter receives the zeroth diffraction order of the first light in a first area of the continuous variable filter, and the zeroth order of the second light in a second area of the continuous variable filter. The continuous variable filter also receives the non-zeroth diffraction order of the first light outside of the first area, and the non-zeroth order of the second light outside of the second area. The continuous variable filter transmits or reflects the zeroth diffraction order of the first light by the first area and the zeroth diffraction order of the second light by the second area. The continuous variable filter blocks the non-zeroth order of the first light outside of the first area, and the non-zeroth order of the second light outside of the second area.

According to another aspect of the current disclosure there is provided a non-transitory computer program product comprising machine-readable instructions therein. The instructions, upon execution by a computer system may be configured to cause the computer system to control a source selection module as described herein for executing a method as described above.

According to another aspect of the current disclosure there is provided a processor and associated storage medium. The storage medium may comprise the non-transitory computer program described above such that said processor is operable to control a source selection module as described herein for executing a method as described above.

According to another aspect of the current disclosure there is provided a metrology device comprising the processor and associated storage medium as described above, so as to be operable to control a source selection module as described herein for executing a method as described above.

According to another aspect of the current disclosure there is provided a lithographic apparatus comprising a source selection module as described herein.

According to another aspect of the current disclosure there is provided a lithographic cell comprising the processor and associated storage medium as described above so as to be operable to control a source selection module according as described herein for executing a method as described above.

### BRIEF DESCRIPTION OF THE DRAWINGS

Embodiments of the invention will now be described, by way of example only, with reference to the accompanying drawings, in which:
Figure 1 depicts a lithographic apparatus;
Figure 2 depicts a schematic overview of a lithographic cell;
Figure 3 depicts a schematic representation of holistic lithography, representing a cooperation between three key technologies to optimize semiconductor manufacturing;
Figure 4 depicts a schematic overview of a scatterometry apparatus used as a metrology device, which may comprise a dark field digital holographic microscope according to embodiments of the invention;
Figure 5 comprises (a) a schematic diagram of a dark field scatterometer for use in measuring targets using a first pair of illumination apertures, (b) a detail of diffraction spectrum of a target grating for a given direction of illumination;
Figure 6 is a schematic illustration of a grating light valve, illustrating its basic operation in (a) a top view, (b) an end-on view in a first configuration and (c) an end-on view in a second configuration;
Figure 7 is a schematic representation of radiation interacting with a grating light valve;
Figure 8 is a schematic representation of an example zeroth order radiation selection;
Figure 9 is a schematic representation of an example setup for a wavelength selection module;
Figure 10 is a schematic representation of an aperture stop for selecting zeroth order diffracted radiation;
Figure 11 is a schematic representation of an example source selection module comprising a continuous variable filter; and
Figure 12 is a schematic representation of wavelength selection using an adjustable diffraction element and a continuous variable filter.

### DETAILED DESCRIPTION

Before describing embodiments of the invention in detail, it is instructive to present an example environment in which embodiments of the present invention may be implemented.

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, UV, visible, and IR radiation (e.g. in a range from 100nm - 2,000 nm), electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

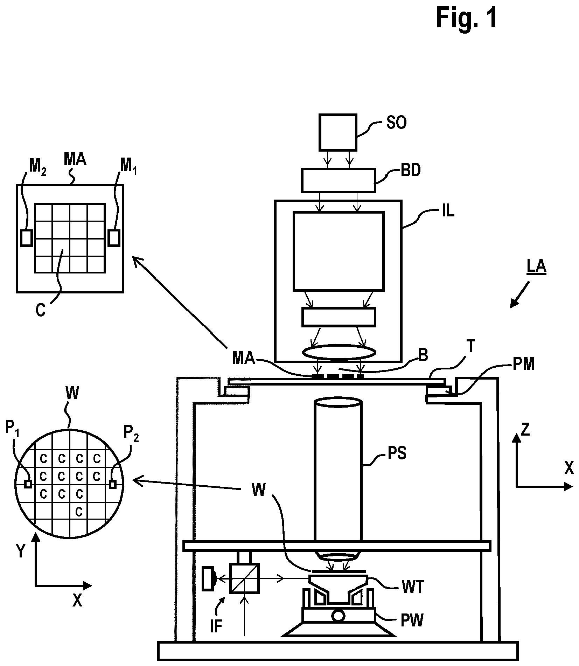

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

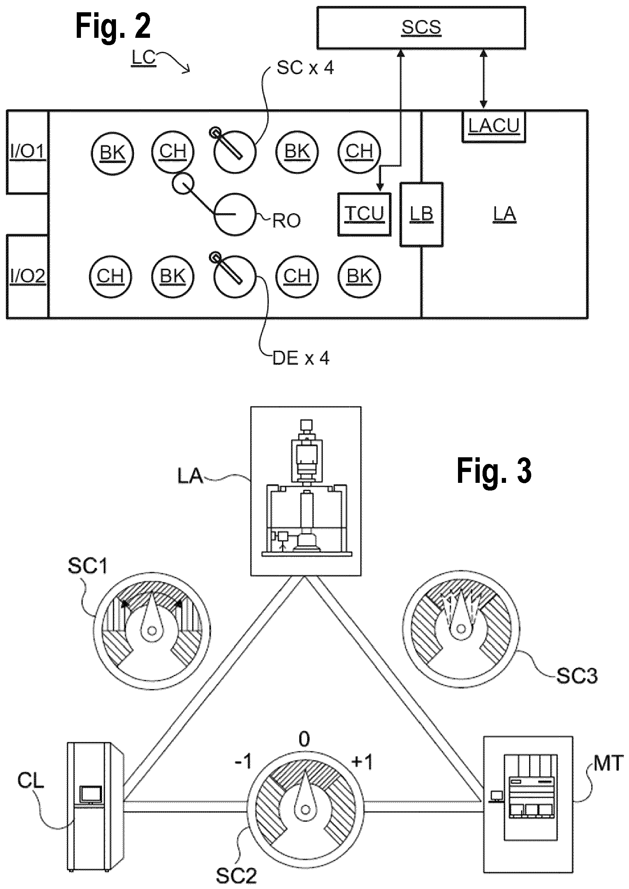

As shown in Figure 2 the lithographic apparatus LA may form part of a lithographic cell LC, also sometimes referred to as a lithocell or (litho)cluster, which often also includes apparatus to perform preand post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra. Additionally and/or alternatively, the scatterometer MT may measure intensity of measured radiation.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and linewidth of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SCI). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are other elements to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

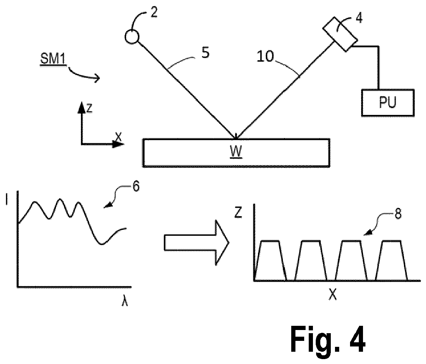

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016/0161863 and published US patent application US 2016/0370717A1 incorporated herein by reference in its entirety.

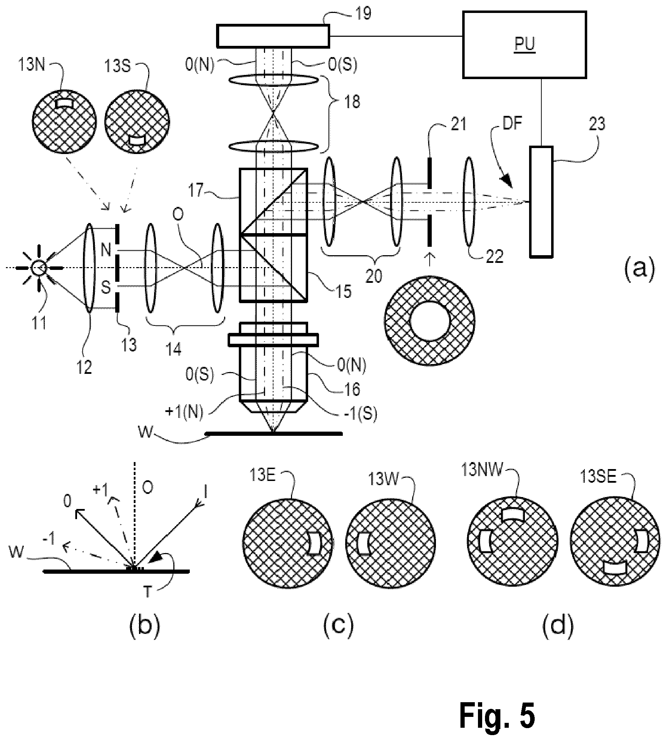

Another type of metrology apparatus is shown in Figure 5(a). A target T and diffracted rays of measurement radiation used to illuminate the target are illustrated in more detail in Figure 5(b). The metrology apparatus illustrated is of a type known as a dark field metrology apparatus. The metrology apparatus depicted here is purely exemplary, to provide an explanation of dark field metrology. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2nd, 3rd and higher order beams (not shown in Figure 5) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented.

A light source (which may also referred to as radiation source) for metrology applications usable for concepts disclosed herein may comprise a broadband source and a color selection arrangement (which may also be referred to as a wavelength selection arrangement or module) to select one or more colors from the broadband output. By way of an example, the radiation source may be based on a hollow core or solid core fiber such as a hollow core photonic crystal fiber (HC-PCF) or solid core photonic crystal fiber (SC-PCF). For example, in the case of a HC-PCF, the hollow core of the fiber may be filled with a gas acting as a broadening medium for broadening input radiation. Such a fiber and gas arrangement may be used to create a supercontinuum radiation source. Radiation input to the fiber may be electromagnetic radiation, for example radiation in one or more of the infrared, visible, UV, and extreme UV spectra. The output radiation may consist of or comprise broadband radiation, which may be referred to herein as white light. This is only one example of a broadband light source technology usable in methods and apparatuses disclosed herein, and other suitable technologies may instead be employed. The output radiation may comprise radiation in a range of 400 nm to 900 nm. The output radiation may comprise radiation in a range from 400 nm to 3000 nm.

When using metrology sensors, including those described above and/or other types of metrology sensors (e.g., alignment sensors, levelling sensors), it is often desirable to control the illumination spectrum, e.g., to switch the illumination between different wavelengths (colors) and/or wavefront profiles.

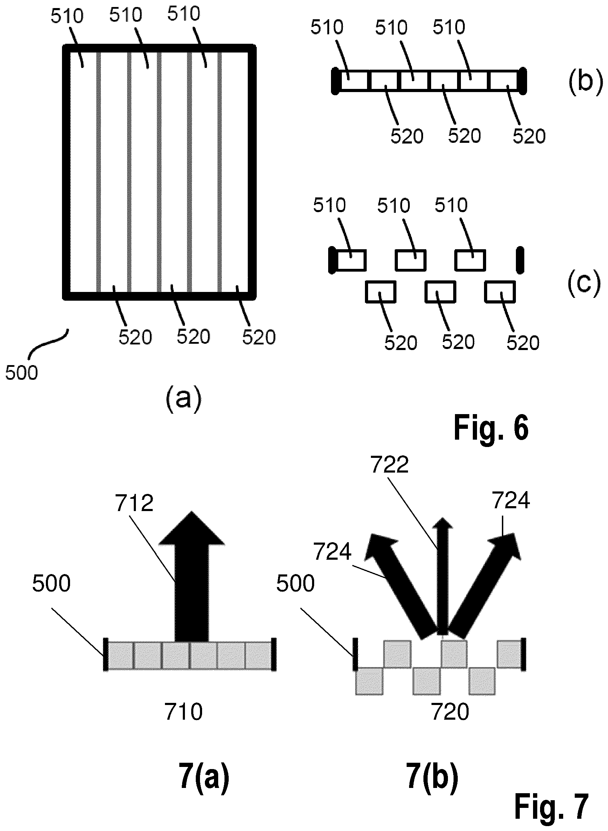

To perform color selection, a color selection module (also referred to as a wavelength selection module, or a source selection module) has been proposed which uses grating light valve (GLV) technology such as marketed by Silicon Light Machines (SLM), e.g., as described in US6947613B, incorporated herein by reference. A GLV is an electrically-programmable diffraction grating based on Micro-Electro-Mechanical Systems (MEMS) technology. Figure 6 schematically illustrates the principle. Figure 6 is a schematic illustration of a GLV pixel also referred to as GLV component 500 from 6(a) above and 6(b), 6(c) end-on. Each pixel/component of a GLV may comprise a controllable grating. The controllable grating may comprise alternating GLV reflective ribbons of two types: static or bias ribbons 510 which are typically grounded along with a common electrode and driven or active ribbons 520 which are driven by an electronic driver channel. A GLV module may comprise any number of these GLV components 500 arranged in an array. The active and bias ribbons may be essentially identical other than in how they are driven. When no voltage is applied to the active ribbons 520, they are co-planar with the bias ribbons, a configuration illustrated in Figure 6(b). In this configuration, the GLV acts essentially as a mirror, with incident light being specularly reflected (i.e., forming specularly reflected radiation or zeroth diffraction order radiation). When a voltage is applied to the active ribbons 520, as illustrated in Figure 6(c), they deflect relative to the bias ribbons 510, establishing a square-well diffraction grating. In this state, incident light may be diffracted into fixed diffraction angles (corresponding to diffraction orders). The ratio of light reflected with respect to light diffracted can be continuously varied by controlling the voltage on the active ribbons 520, which controls the magnitude of their deflection. As such, the amount of light diffracted by the GLV can be controlled in an analog fashion from zero (full specular reflection) to all incident light (zero specular reflection). This control of the amount of reflected radiation with respect to the amount of radiation diffracted into nonzero diffraction orders may be referred to as modulating the illumination within the context of this disclosure.

Figure 7 depicts a schematic illustration of radiation after it has interacted with GLV pixel 500. In figure 7(a) GLV pixel 500 is in an unbiased state, acting like a mirror 710, specularly reflecting radiation 712 (also referred to as zeroth diffraction order radiation 712). In figure 7(b) a bias voltage is applied to create a diffraction grating 720 in GLV pixel 500. The diffraction grating 720 may diffract a portion of the radiation into a zeroth diffraction order 722. Another portion of the radiation may be diffracted into higher (non-zeroth) diffraction orders 724, such as positive first +1 and negative first -1 diffraction orders. The portion of radiation directed away from the zeroth diffraction order 722 (into non-zeroth diffraction orders 724) may be controlled by tuning the grating 720 through the depth of the active pixels 520 compared to static pixels 510.

A GLV may comprises multiple ribbons, and at least a portion of the ribbons may be configured to be movable. Other light valve technologies such as Digital Light Processing (DLP), Liquid Crystal Display (LCD), and liquid crystal on silicon (LCoS), may be used for implementation in video projector devices such as rear-projection televisions and digital projection. The use of microelectromechanical systems (MEMS) in optical applications, which is known as optical MEMS or micro-opto-electro-mechanical structures (MOEMS), has enabled the possibility to combine the mechanical, electrical and optical components in very small scale.

The GLV module may be used in a zeroth order mode such that the non-zeroth order diffracted radiation is blocked/dumped and the specularly reflected (zeroth diffraction order) radiation is provided to the metrology tool. This may have the advantage of preserving etendue. As such, an aperture stop may be provided in a pupil plane which with the aim of maximizing transmission of the zeroth order, and maximizing blocking (minimizing transmission) of the first diffraction orders (and other non-zero diffraction orders).

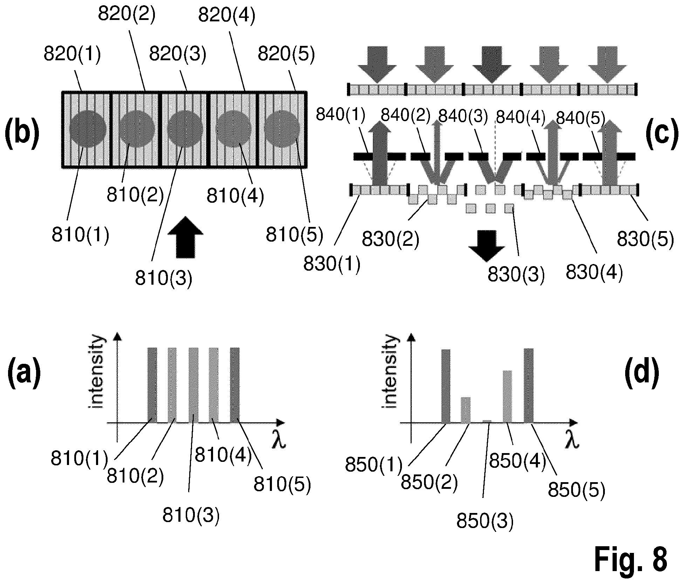

An example setup using zeroth order mode radiation selection is depicted in Figure 8(a) shows input radiation 810, which may comprise radiation in a range of wavelengths 810(1), 810(2), 810(3), 810(4), 810(5). In figure 8(b), each radiation wavelength 810(1), 810(2), 810(3), 810(4), 810(5) may be incident on a separate GLV pixel 820(1), 820(2), 820(3), 820(4), 820(5). In some embodiments, each element 820(1), 820(2), 820(3), 820(4), 820(5) may represent a plurality of GLV pixels. In figure 8(c), a side-on view of GLV pixels with bias applied 830(1), 830(2), 830(3), 830(4), 830(5) is shown. Pixels 830(1) and 830(5) have no bias applied, and therefore may act as mirrors, specularly reflecting output radiation 850(1) and 850(5), shown in figure 8(d). Pixels 830(2), 830(3) and 830(4) have a bias applied to form diffraction gratings, such that a portion of the radiation is diffracted into non-zeroth orders. The portion of zeroth order radiation may be dependent on the depth of the grating (i.e. dependent on the bias applied). For example, in figure8(c), relative to each other, pixel 830(4) has a small grating depth, pixel 830(3) has a large grating depth, and pixel 830(2) has a medium grating depth. The resulting intensity of radiation diffracted into the zeroth order is low in 850(3), medium in 850(2), and higher in 850(4). The remaining proportion or radiation not diffracted into the zeroth order, is diffracted into non-zeroth orders. This non-zeroth diffracted radiation may be blocked/stopped by aperture stops 840(1), 840(2), 840(3), 840(4), 840(5). Although depicted in figure 8 as a set of discrete wavelengths, the radiation 810(1), 810(2), 810(3), 810(4), 810(5) may additionally and/or alternatively comprise one or more continuous wavelength ranges of radiation.

Challenges may exist with the use of aperture stops for filtering out diffracted radiation. The diffraction angle of radiation is dependent on wavelength. In addition, spot size in the pupil plane may also be wavelength dependent, such that each color has a different spot size in the pupil plane. For example, a source presently used in some metrology applications may comprise a different etendue for different colors of light, such that respective beam widths for different colors are different. Because of this, it is difficult to configure the aperture stop to maximize transmission of the zeroth order blocking of the first orders, for all wavelengths of interest (e.g., the wavelength band covered by a source selection module). Any particular shape or configuration for a hard aperture stop may be sub-optimal for certain wavelength ranges (e.g., may result in too much blockage of the zeroth order and/or too much leakage of first orders in the transmission window). As the used wavelength range increases, the problem becomes larger.

This issue is exacerbated when using a beam with a high etendue. A high etendue beam makes it difficult to minimize the spot size (per wavelength) on the GLV, and to have a low numerical aperture (NA) per order. A small spot on the GLV is highly desirable so as to operate on the flat area of the activated ribbons, and therefore not to lose contrast. A low NA of the orders is beneficial for separation of zeroth and first orders over a number of wavelengths.

A known color selection module arrangement based on a controllable diffractive element such as a GLV may comprise a beam dispersing element for dispersing the broadband illumination beam; a controllable diffractive element or GLV module for spatially modulating the broadband illumination beam subsequent to being dispersed; an aperture stop in the far field (a pupil plane, or conjugate thereof, of the GLV) to remove all but the wanted order(s) (e.g., to remove all but the zeroth order; however this may be reversed such that the zeroth order is blocked and first orders transmitted); and a beam combining element to recombine the spatially modulated broadband illumination beam to obtain an output source beam. The beam dispersing element may disperse the colors of a white light source over the GLV in a first direction (e.g., where the GLV is comprised in an image plane or field plane of the system). The combining element and dispersive element may be different elements or a single element.

Metrology tools MT, such as a scatterometer, topography measurement system, or position measurement system mentioned above may use radiation originating from a radiation source to perform a measurement. The properties of the radiation used by a metrology tool may affect the type and quality of measurements that may be performed. For some applications, it may be advantageous to use different and/or multiple radiation frequencies to measure a substrate, for example broadband radiation, or one or more bands within a broadband range may be used. In some instances narrowband radiation may be advantageous for measurements. Multiple different frequencies may be able to propagate, irradiate, and scatter off a metrology target with no or minimal interference with other frequencies. Therefore different frequencies may for example be used to obtain more metrology data simultaneously. Different radiation frequencies may also be able to interrogate and discover different properties of a metrology target. Broadband radiation may be useful in metrology systems MT such as for example level sensors, alignment mark measurement systems, scatterometry tools, or inspection tools. A broadband radiation source may be a supercontinuum source. In some instances, some bands within a broadband radiation range may be selected for performing measurements.

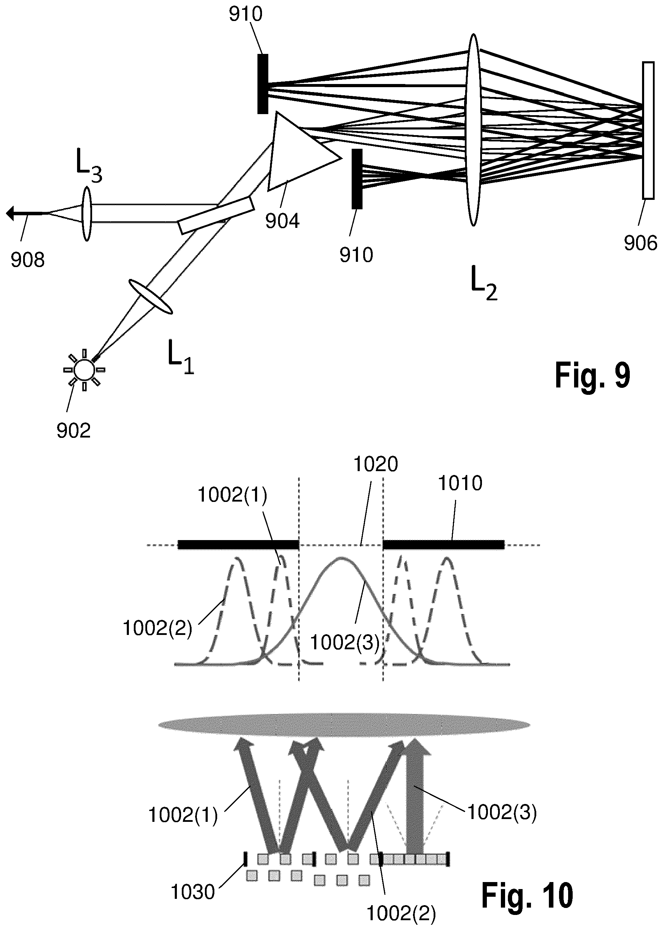

In some metrology tools, narrowband radiation around a predefined wavelength may be controllably selected from provided broadband radiation. The radiation may for example comprise broadband light in a range from 400 nm to 900 nm, or in a range from 400 nm to 2000 nm. Selection of narrowband radiation may for example be achieved with a grating light valve, which may be based for example on the disclosure in US6947613B. An example schematic representation of a setup for selecting narrow bands of radiation from received broadband input radiation using a grating light valve is shown in figure 9. Input broadband radiation 902 may be provided by broadband input source. The broadband radiation may be spatially distributed across wavelengths by a prism 904. The spatially divided radiation of different wavelengths may be guided onto different pixels of a GLV 906. The GLV may be driven electronically (e.g. receiving instructions on which biases to apply to the pixels from one or more connected processors) to set how much radiation is diffracted (and/or specularly reflected) into the zeroth order. The zeroth order diffracted radiation may be referred to as the output spectrum. The output spectrum may be guided back through a prism, which may be the same prism 904 used to separate the input radiation or a different prism (not shown). The prism may combine the distributed output spectrum to form output radiation 908 comprising a combination of the different wavelengths of the output spectrum. Optical elements (e.g. LI, L2, L3) may be used to guide the radiation through the setup. Non-zeroth order radiation may be blocked, e.g. by radiation stops 910.

In the designs described herein, a trade-off may need to be made between the zeroth order transmission and a spectral contrast ratio (e.g. out-of-band radiation suppression/blocking ratio). Figure 10 depicts a schematic illustration of an aperture stop 1010 for selecting some radiation, and blocking other radiation. In the image, the central zeroth order diffracted radiation 1002(3) (e.g. longer wavelength red light) diffracted by the adjustable diffraction element (GLV) 1030 may be passed through the aperture opening 1020, and non-zeroth order diffracted radiation 1002(1), 1002(2) (e.g. shorter wavelength green and purple light) may be blocked by the aperture 1020.

The aperture opening 1020 may have a size that is small enough to block all non-zeroth order wavelengths. However, making the aperture opening smaller to block more non-zeroth order radiation may lead to some zeroth order radiation to be blocked as well. This may result in reduced transmission and therefore lower power efficiency. On the other hand, making the aperture opening larger to increase zeroth order radiation transmission may lead to more non-zeroth order radiation to be let through, making the aperture 1010 less effective at blocking non-zeroth order diffracted radiation. This may lead to a worse spectral contrast ratio in the output spectrum (i.e. more noise/unwanted radiation). Furthermore, chromatic aberrations may make the positioning of the aperture challenging to be effective for selecting/blocking different wavelengths across the spectrum of received radiation. Due to the challenges presented by aperture stops for blocking and selection different wavelengths of radiation, alternative solutions may be desirable.

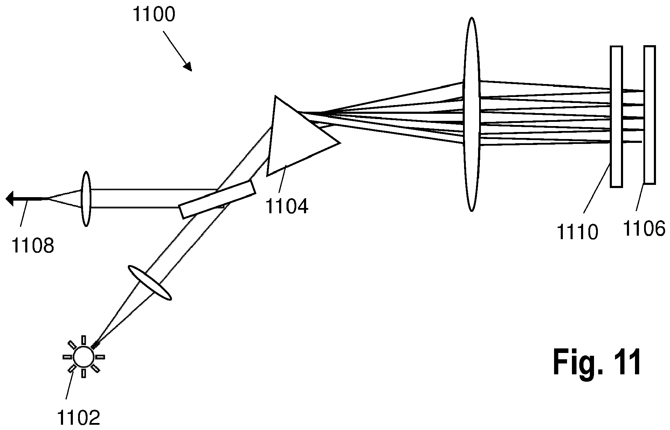

It is proposed herein to provide a source selection module 1100 according to figure 11. The source selection module may also be referred to as a wavelength selection module. The module may comprise a color selection arrangement as described above. Similarly to figure 9 above, input radiation 1102 may be provided. The input radiation may be referred to as light. A light dispersive element 1104 (such as e.g. a prism, a light dispersive grating, a combination of a prism and a light dispersive grating, etc.) may be configured to receive light 1102 comprising first light of a first wavelength and second light of a second wavelength (different from the first light/first wavelength). The first light and second light may be spatially distributed by the light dispersive element 1104 such that they hit first and second pixels (wherein the first and second pixels are different pixels) of an adjustable diffraction element 1106 (e.g. a grating light valve). The grating light valve may be configured to be able to generate zeroth order diffracted first light and non-zeroth order diffracted first light. The grating light valve may further be configured to be able to generate zeroth order diffracted second light and non-zeroth order diffracted second light. A continuous variable filter 1110 is further provided as part of the source module, comprising a first area and a second area, wherein the first area is configured to transmit (or reflect) first light, and wherein the second area is configured to transmit (or reflect) second light. The continuous variable filter is arranged at a position in the source selection module 1100 such that the zeroth order of the first light is received by the first area, and the zeroth order of the second light is received by the second area. The continuous variable filter is further configured to block first light outside the first area and to block second light outside the second area.

An advantage of using a source selection module as described above, may be that an aperture stop used for blocking non-zeroth orders of diffracted radiation is no longer required. Instead, the wavelengthspecific transmission properties of the continuous variable filter (CVF) may be used to block the non-zeroth order radiation in the same location as transmitting (or reflecting) zeroth order radiation in its corresponding area. The use of a CVF may improve the performance of the source selection module. Improved performance may for example include higher zeroth order transmission and/or a higher spectral contrast ratio (better blocking of unwanted radiation). The use of a CVF may also reduce risks of chromatic aberration and misalignment of the optical elements in the source selection module.

The adjustable diffraction element may comprise a grating light valve. Each of the pixels of the adjustable diffraction element may comprise a controllable diffraction grating. The input radiation may be broadband radiation. Controllable, in this context, may refer to tunable, for example as described in relation to figures 5 and 6 above.

Although described for first light and second light in relation to figure 11 above, the continuous variable filter may function for a plurality N of different wavelengths (N ≥ 2), wherein each wavelength of n^{th} light is configured to be transmitted by a corresponding n^{th} area on the continuous variable filter CVF, and blocked by areas outside of the n^{th} corresponding area.

Continuous variable filters may be commercially available. A CVF may be an edgepass CVF. A CVF may comprise a continuously variable bandpass layer (also referred to as a bandpass CVF). Bandpass CVF with high transmission (for the desired wavelength) and high contrast (i.e. high blocking of other wavelengths) can be achieved. In an example implementation of a bandpass CVF, a bandpass coating may be continuously varied along a direction of the CVF. The coating may for example comprise repeated alternating thin layers of two or more different materials (e.g. alternating layers of SiO₂ and Ta₂O₅). Such a layer configuration is provided as an example only, and other layer configurations are known and may be used herein. Varying the thickness of the layers along a dimension of the CVF may result in different locations along this direction providing a narrow transmission band around a particular center wavelength. The center wavelength may continuously vary along the direction along with the varying thicknesses of the bandpass coating. This may lead to narrow transmission bands along the varying direction of the CVF, for varying wavelengths. As the filter is a bandpass filter, radiation of wavelengths falling outside the narrow bandpass band may be blocked by the filter.

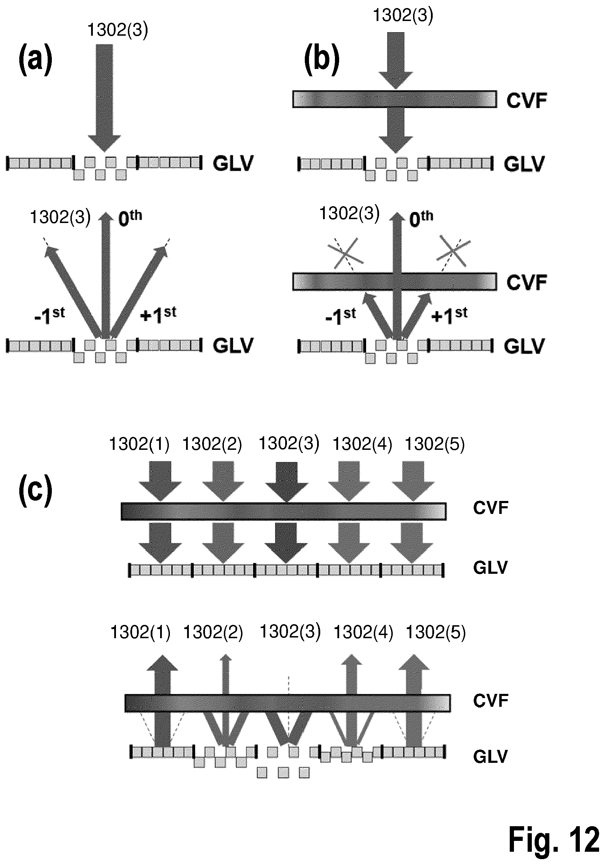

Figure 12 depicts a schematic representation of the functioning of a continuous variable filter in combination with an adjustable diffraction element in order to achieve wavelength selection. In figure 12(a), a GLV (a type of adjustable diffraction element) is shown, wherein a bias has been applied to the pixel receiving radiation of wavelength 1302(3). In the top image, the input radiation 1302(3) is incident upon the pixel with the applied diffraction grating. In the bottom image, the radiation is diffraction, with a portion of the radiation being diffracting into the zeroth order, and other portions being diffracted into higher, non-zeroth order diffraction orders (+1 and -1 orders illustrated in the figure). The zeroth order radiation will take the same optical path as the incoming radiation 1302(3), meaning both the incoming radiation and outgoing zeroth order radiation pass through the same location on the CVF. In figure 12(b) a continuous variable filter CVF is added to the setup. The GLV still diffracts the received radiation 1302(3) as in figure 12(a). The non-zeroth order diffracted radiation is incident on a location of the CVF that is configured to block radiation of the wavelength 1302(3). Only the zeroth order diffracted radiation of 1302(3) passes through the CVF at a location that transmits radiation of the wavelength of 1302(3). As a result, non-zeroth order diffracted radiation is blocked. In figure 12(c), radiation of a plurality of different wavelengths 1302(1), 1302(2), 1302(3), 1302(4), 1302(5) may be incident upon a plurality of different pixels of a GLV. Each pixel may have a bias voltage applied to select how much radiation is diffracted/specularly reflected into the zeroth order. The CVF then blocks non-zeroth order diffracted radiation that is incident on the CVF at a location where its wavelength does not fall within the transmission band of the continuous variable filter. The module may be set up such that the separated wavelengths incident upon the GLV may be aligned with the corresponding bandpass central wavelengths of the CVF.

The continuous variable filter may be arranged in an optical path between the light dispersive element and the adjustable diffraction element. The position of the continuous variable filter, specifically its distance from the adjustable diffraction element, may affect its functionality regarding blocking and/or transmitting (or reflecting) wavelengths of radiation.

The position of the CVF may determine where the non-zeroth order diffracted radiation hits the CVF. The position of the CVF along a plane perpendicular to the optical path of the zeroth order diffracted radiation may be selected based relative to the position of the GLV (and the light dispersive element). This may for example be chosen so that the paths of the distributed wavelengths align with the transmission bands of the CVF for that wavelength. These may in turn also align with a pixel of the GLV (or other equivalent adjustable diffraction element) configured to diffract radiation of that particular distributed wavelength. The position of the CVF along a direction parallel to the zeroth order diffracted radiation path may be chosen to be in close proximity to the GLV. An aim is to have enough separation of the non-zeroth order diffracted radiation in the plane perpendicular to the zeroth order optical path, so that the non-zeroth order diffracted radiation does not hit the CVF within the transmission window for that wavelength. Separation of the zeroth and non-zeroth diffraction orders is required at the CVF. This may be achieved for example by allowing the diffracted radiation to propagate for a distance L, by placing the CVF a distance L away from the surface of the GLV. For a ±1 order diffraction angle θ, the distance d between the zeroth order radiation and the first order radiation at the CVF may be d = *L* tan (*θ*).

In an approximate calculation of example distances and angles to be used in a source selection module as described herein, a GLV may be provided with a pitch of approximately 8.5µm. Based on this pitch and incident radiation in a range of 400 nm to 900 nm, the resulting diffraction angle may be calculated as: arcsin([400*nm* - 900*nm*]/8.5*µm*) = 2.7 - 6.1 *degrees* = *θ*. A small divergence from normal incidence of the incoming radiation may have a negligible impact on the spectral performance of the CVF. If a distance L = 5 *mm* between the CVF and the GLV is used, the first diffracted order will be projected on the CVF at a location with a lateral shift d away from the zeroth order: d = 5mm * tan (*θ*) = 236µm - 534µm (for 400 nm - 900 nm incident light). When a GLV is used with a 16 mm array size used for a 400nm-900nm radiation range (so a 500nm range width), the (average) variable ratio of the CVF may be approximately 31nm/mm (500nm/16mm = 31.25nm/mm ≈ 31nm/33). That is to say, a CVF with 31nm of bandpass wavelength variation along 1 mm of distance along the CVF. It should be understood that the calculations set out herein are approximate, and a simplified version of a real-world setup. They are for illustrative purposes only, and should not be considered as limiting. For a CVF with a 31nm/mm variable ratio, the short wavelengths hit the CVF with a 0.236 mm lateral shift, corresponding to a ±7.3 nm wavelength shift away from the aligned 400 nm wavelength bandpass. For a CVF with a 31nm/mm variable ratio, the long wavelengths hit the CVF with a 0.534 mm lateral shift, corresponding to a ±16.6nm wavelength shift away from the aligned 900nm wavelength bandpass. These wavelengths shifts may be sufficient to block the first diffraction orders hitting the CVF. In some implementations, wavelengths shifts down to 1 - 2 nm may be acceptable for blocking the desired diffraction orders.

For incident wavelength other than the 400nm-900nm example worked out above, ranges the required dimensions and diffraction angles may be adjusted accordingly. As illustrated in the example above when the propagation length L decreases, the resulting distance between zeroth and first orders also decreases. In the application described herein, overlap between different diffraction orders (in particular overlap between the zeroth and ±1 orders) is undesirable. Therefore, a minimum separation distance dₘᵢₙ may be determined, when the zeroth and first order diffracted spots are right next to each other. For example, in the worked example in the paragraph above, a spot size may be of an order of 50µm - 70 µm. A dₘᵢₙ of 70µm may be selected, which for the example setup above may lead to a propagation length L of approximately 1.5 mm. When L increases, the separation between orders (e.g. zeroth and ±1 orders) on the CVF increases. This may make the transmitting and blocking of desired orders easier. However, the CVF may be limited in its placement by other elements in the optical system. For example, the CVF may be limited in placement by the last lens in front of the LV, Therefore, in an example implementation, the placement of such a lens may limit the length L. The maximum propagation length L (distance between GLV and CVF) may for example in the in a range from 50 mm to 100 mm (approximately).

Next to the position of the CVF in the proximity of the adjustable diffraction element as described above, the CVF may alternatively be placed in an equivalent position (i.e. at a same distance) of a conjugate plane of the adjustable diffraction element in the optical path of the source selection module.

The continuously variable filter may have a filtering characteristic (e.g. bandpass filtering characteristic) that is linearly distributed over the area of the continuous variable filter. The CVF may for example be a rectangular strip, wherein the filtering characteristic varies linearly along a first direction. This may be the same direction as the direction along which the wavelengths of incoming radiation are distributed, and/or the direction along which the different pixels of the adjustable diffraction element are positioned. The filtering characteristic may be constant along a second direction of the CVF. The second direction may be perpendicular to the first direction.

In some implementations, the filtering characteristic may be non-linearly distributed over the area of the continuous variable filter. The non-linear distribution may for example be designed to match a non-linear distribution of wavelengths of the radiation and/or GLV pixels. For example, depending on the dispersive properties of the light dispersive element (e.g. prism), the wavelengths of the incident broadband light may be dispersed in a non-linear manner. The distribution of the pixels on the GLV and/or the wavelength-dependent bandpass windows of the CVF may be engineered to match this non-linear distribution.

The CVF may be placed in close proximity L to the GLV, as discussed above. In another embodiment, the CVF may be used to replace a protection window of the GLV. In some embodiments, the protection window of the GLV may be coated with a CVF coating. The protection window may be provided to protect the MEMS (micro-electro-mechanical systems) components of the adjustable diffraction element. As a MEMS device, the GLV may require a protection window. The protection window may be tilted in order to reduce possible ghost reflections form the window. The tilted angle of the window may divert ghost reflection beams to a region outside the 0th order beams, thus preventing interference between the two. In an implementation where a CVF replaces or is incorporated with the protection window, the CVF layer may be tilted relative to a plane of the adjustable diffraction element. An advantage of the CVF replacing the protection window may be that the number of surfaces the radiation passes through is reduced, which may increase transmission, and/or may reduce aberrations/noise.

Further embodiments are disclosed in the subsequent numbered clauses:
1. A source selection module comprising
   an adjustable diffraction element comprising multiple pixels;
   a light dispersive element configured for receiving a first light of a first wavelength and a second light of a second wavelength, spatially distributing the first light over a first pixel of the multiple pixels to generate a zeroth diffraction order of the first light and a non-zeroth diffraction order of the first light, and spatially distributing the second light over a second pixel of the multiple pixels to generate a zeroth diffraction order of the second light and a non-zeroth diffraction order of the second light; and
   a continuous variable filter comprising a first area and a second area;
   wherein the continuous variable filter is arranged at a position such that the zeroth order of the first light received by the first area and the zeroth order of the second light received by the second area are transmitted or reflected by the continuous variable filter, the non-zeroth order of the first light is blocked by the continuous variable filter outside of the first area, and the non-zeroth order of the second light is blocked by the continuous variable filter outside of the second area.
2. A source selection module according to clause 1, wherein each of the multiple pixels comprises a controllable grating.
3. A source selection module according to clause 2, wherein the adjustable diffraction element comprises a grating light valve.
4. A source selection module according to any of the preceding clauses, wherein the continuous variable filter is arranged on an optical path between the light dispersive element and the adjustable diffraction element.
5. A source selection module according to any of the preceding clauses, wherein the continuous variable filter is arranged at a distance from the adjustable diffraction element or at a distance from a conjugate image plane of the adjustable diffraction element, such that the zeroth diffraction order and non-zeroth diffraction order of the first light and the zeroth diffraction order and non-zeroth diffraction order of the second light are spatially separated.
6. A source selection module according to any of the preceding clauses, wherein the light dispersive element comprises a prism.
7. A source selection module according to any of clauses 1 to 5, wherein the light dispersive element comprises a light dispersive grating.
8. A source selection module according to any of the preceding clauses, wherein the continuous variable filter comprises a continuously varying bandpass layer.
9. A source selection module according to any of the preceding clauses, wherein a plane of the continuous variable filter is tilted relative to a plane of the adjustable diffraction element.
10. A source selection module according to any of the preceding clauses, wherein a filtering characteristic is linearly distributed over the area of the continuous variable filter.
11. A source selection module according to any of clauses 1 to 9, wherein a filtering characteristic is non-linearly distributed over the area of the continuous variable filter.
12. A source selection module according to any of preceding clauses, wherein the continuous variable filter has a first optical filtering characteristic in the first area and a second optical filtering characteristics in the second area.
13. A source selection module according to any of the preceding clauses, wherein the first wavelength and the second wavelength are both in a range from 400 nm - 900 nm.
14. A method, comprising:
   receiving a first light of a first wavelength and a second light of a second wavelength
   spatially distributing, by a light dispersive element, the first light over a first pixel of an adjustable diffraction element comprising multiple pixels, and spatially distributing the second light over a second pixel of the multiple pixels of the adjustable diffraction element;
   generating, by the first pixel, a zeroth diffraction order of the first light and a non-zeroth diffraction order of the first light, and generating, by the second pixel, a zeroth diffraction order of the second light and a non-zeroth diffraction order of the second light; and
   receiving, by a continuous variable filter, the zeroth diffraction order of the first light in a first area of the continuous variable filter, the zeroth order of the second light in a second area of the continuous variable filter, the non-zeroth diffraction order of the first light outside of the first area, and the non-zeroth order of the second light outside of the second area;
   transmitting or reflecting, by the continuous variable filter, the zeroth diffraction order of the first light by the first area and the zeroth diffraction order of the second light by the second area; and
   blocking, by the continuous variable filter, the non-zeroth order of the first light outside of the first area, and the non-zeroth order of the second light outside of the second area.
15. A non-transitory computer program product comprising machine-readable instructions therein, the instructions, upon execution by a computer system, configured to cause the computer system to control a source selection module according to any of clauses 1 - 13 for executing a method according to clause 14.
16. A processor and associated storage medium, said storage medium comprising the non-transitory computer program of clause 15 such that said processor is operable to control a source selection module according to any of clauses 1 - 13 for executing a method according to clause 14.
17. A metrology device comprising the processor and associated storage medium of clause 16 so as to be operable to control a source selection module according to any of clauses 1 - 13 for executing a method according to clause 14.
18. A lithographic apparatus comprising a source selection module according to any of clauses 1 - 13.
19. A lithographic cell comprising the processor and associated storage medium of clause 15 so as to be operable to control a source selection module according to any of clauses 1 - 13 for executing a method according to clause 14.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (nonvacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to certain types of electromagnetic radiations, it will be appreciated that the invention, where the context allows, may be practiced with all electromagnetic radiations, includes radio waves, microwaves, infrared, (visible) light, ultraviolet, EUV, SXR, HXR and gamma rays.

While specific embodiments have been described above, it will be appreciated that one or more of the features in one embodiment may also be present in a different embodiment and that features in two or more different embodiments may also be combined.

## Claims

1. A source selection module comprising
an adjustable diffraction element comprising multiple pixels;
a light dispersive element configured for receiving a first light of a first wavelength and a second light of a second wavelength, spatially distributing the first light over a first pixel of the multiple pixels to generate a zeroth diffraction order of the first light and a non-zeroth diffraction order of the first light, and spatially distributing the second light over a second pixel of the multiple pixels to generate a zeroth diffraction order of the second light and a non-zeroth diffraction order of the second light; and
a continuous variable filter comprising a first area and a second area;
wherein the continuous variable filter is arranged at a position such that the zeroth order of the first light received by the first area and the zeroth order of the second light received by the second area are transmitted or reflected by the continuous variable filter, the non-zeroth order of the first light is blocked by the continuous variable filter outside of the first area, and the non-zeroth order of the second light is blocked by the continuous variable filter outside of the second area.

2. A source selection module according to claim 1, wherein each of the multiple pixels comprises a controllable grating, and wherein optionally the adjustable diffraction element comprises a grating light valve.

3. A source selection module according to any of the preceding claims, wherein the continuous variable filter is arranged on an optical path between the light dispersive element and the adjustable diffraction element.

4. A source selection module according to any of the preceding claims, wherein the continuous variable filter is arranged at a distance from the adjustable diffraction element or at a distance from a conjugate image plane of the adjustable diffraction element, such that the zeroth diffraction order and non-zeroth diffraction order of the first light and the zeroth diffraction order and non-zeroth diffraction order of the second light are spatially separated.

5. A source selection module according to any of the preceding claims, wherein the light dispersive element comprises a prism, and/or a light dispersive grating.

6. A source selection module according to any of the preceding claims, wherein the continuous variable filter comprises a continuously varying bandpass layer.

7. A source selection module according to any of the preceding claims, wherein a plane of the continuous variable filter is tilted relative to a plane of the adjustable diffraction element.

8. A source selection module according to any of the preceding claims, wherein a filtering characteristic is linearly distributed over the area of the continuous variable filter.

9. A source selection module according to any of claims 1 to 7, wherein a filtering characteristic is non-linearly distributed over the area of the continuous variable filter.

10. A source selection module according to any of preceding claims, wherein the continuous variable filter has a first optical filtering characteristic in the first area and a second optical filtering characteristics in the second area.

11. A source selection module according to any of the preceding claims, wherein the first wavelength and the second wavelength are both in a range from 400 nm - 900 nm.

12. A method, comprising:
receiving a first light of a first wavelength and a second light of a second wavelength
spatially distributing, by a light dispersive element, the first light over a first pixel of an adjustable diffraction element comprising multiple pixels, and spatially distributing the second light over a second pixel of the multiple pixels of the adjustable diffraction element;
generating, by the first pixel, a zeroth diffraction order of the first light and a non-zeroth diffraction order of the first light, and generating, by the second pixel, a zeroth diffraction order of the second light and a non-zeroth diffraction order of the second light; and
receiving, by a continuous variable filter, the zeroth diffraction order of the first light in a first area of the continuous variable filter, the zeroth order of the second light in a second area of the continuous variable filter, the non-zeroth diffraction order of the first light outside of the first area, and the non-zeroth order of the second light outside of the second area;
transmitting or reflecting, by the continuous variable filter, the zeroth diffraction order of the first light by the first area and the zeroth diffraction order of the second light by the second area; and
blocking, by the continuous variable filter, the non-zeroth order of the first light outside of the first area, and the non-zeroth order of the second light outside of the second area.

13. A non-transitory computer program product comprising machine-readable instructions therein, the instructions, upon execution by a computer system, configured to cause the computer system to control a source selection module according to any of claims 1 - 11 for executing a method according to claim 12.

14. A processor and associated storage medium, said storage medium comprising the non-transitory computer program of claim 13 such that said processor is operable to control a source selection module according to any of claims 1 - 11 for executing a method according to claim 12.

15. A metrology device comprising the processor and associated storage medium of claim 14 so as to be operable to control a source selection module according to any of claims 1 - 11 for executing a method according to claim 12.
